# EUROPEAN PATENT APPLICATION

(11) **EP 4 745 294 A1**
(43) Date of publication of application: **20.05.2026**
(21) Application number: 24860208.8
(22) Date of filing: 31.07.2024
(51) Int. Cl.: D06F 58/20, D06F 58/10, D06F 58/26, D06F 34/08, D06F 58/24, B01D 35/02, D06F 103/54, D06F 103/50, D06F 103/56, D06F 105/36

(54) **CLOTHING TREATMENT APPARATUS**

(30) Priority: 31.08.2023 KR 20230115530
(71) Applicant: LG Electronics Inc., Yeongdeungpo-gu Seoul 07336 (KR)
(72) Inventor: KIM, Jaehyung, Seoul 08592 (KR); JANG, Jinhyuk, Seoul 08592 (KR); YOON, Taejun, Seoul 08592 (KR); PARK, Seungwoo, Seoul 08592 (KR)
(74) Representative: Schornack, Oliver
(86) International application number: PCT/KR2024/011202
(87) International publication number: WO 2025/048287

(57) **Abstract**

A laundry treatment apparatus includes a cabinet, a processing chamber located inside the cabinet and configured to accommodate laundry, a door configured to open and close the processing chamber, a machine compartment provided inside the cabinet and located in a lower portion of the processing chamber, a base module located in the machine compartment and configured to exchange heat with air of the processing chamber, a control board located in a control board installation portion provided in a bottom portion of the machine compartment and configured to control a configuration of the laundry treatment apparatus, and a fan disposed at a vertically overlapping position with respect to the control board and configured to discharge sucked air in a direction away from the control board.

## Description

### [Technical Field]

The present disclosure relates to a laundry treatment apparatus. More specifically, the present disclosure relates to a laundry treatment apparatus for performing deodorization, drying, and wrinkle removal of laundry.

### [Background Art]

In general, a laundry treatment apparatus includes a washing machine that soaks laundry in water and then removes foreign substances from the wet laundry through chemical action of detergent and physical action such as drum rotation, and a dryer that dries the wet laundry using hot air and steam.

In recent years, laundry treatment apparatuses for laundry care including deodorizing dry laundry without soaking it in water, removing moisture from laundry, or removing wrinkles have emerged. These laundry treatment apparatuses perform a refresh course for deodorizing clothes by supplying moisture, steam, or hot air while the clothes are hung, and drying or sterilizing the clothes.

A laundry treatment apparatus may use a heater or a heat pump to dry laundry. The laundry treatment apparatus using the heat pump uses an evaporator and a condenser to dehumidify humid air, heats the air again, and then supplies the dried hot air to the laundry. Compared to the heater, the heat pump may generate high heat with a small amount of energy and thus is excellent in terms of energy efficiency.

The heat pump may dehumidify humid air or heat the air through a refrigerant circulation process. Refrigerants may be categorized into a natural refrigerant, 1st generation chlorofluorocarbon (CFC), 2nd generation hydrochlorofluorocarbon (HCFC), 3rd generation hydrofluorocarbon (HFC), and 4th generation hydrofluoroolefin (HFO). Thereamong, as the CFC and HCFC-based refrigerants classified as freon gases are known as main substances that deplete the ozone layer, use thereof has been regulated by the Montreal Protocol.

The HFC-based refrigerants do not have side effects such as depletion of the ozone layer but act as global warming materials. A representative refrigerant thereof is R-134a. As HFC-based refrigerants were defined as global warming materials pursuant to the Montreal Protocol, use thereof has gradually been phased out. Accordingly, HFO-based refrigerants with a low global warming potential (GWP) are emerging as next-generation refrigerants.

GWP refers to an extent to which other greenhouse gases contribute to global warming, based on an effect of carbon dioxide on global warming. That is, GWP refers to a value obtained by dividing an amount of solar energy absorbed by 1 kg of an individual greenhouse gas by an amount of solar energy absorbed by 1 kg of carbon dioxide. GWP refers to an index of a warming effect per unit mass. For example, when the GWP of carbon dioxide is 1, then the GWP of methane is 21, the GWP of nitrous oxide is 310, the GWP of hydrogen fluoride is 1,300, and the GWP of sulfur hexafluoride is 23,900.

In order to prevent accelerated global warming, use of materials with a high GWP is being restricted worldwide. Accordingly, a heat pump using R-290, which is a refrigerant with a low GWP, and a laundry treatment apparatus using the heat pump have been developed. However, R-290 is high-purity propane gas, which has flammability and combustibility. In particular, when a concentration of R-290 in air becomes higher than 1.8% due to leakage thereof, there is a possibility of ignition or explosion during use.

Therefore, there is a need for an apparatus or a control method capable of detecting leakage of a refrigerant during operation and preventing ignition thereof. A prior art document related to preventing ignition of the refrigerant includes Korean Laid-Open Patent Publication No. 10-2021-0001769 (prior art document 1). Prior art document 1 discloses a laundry treatment apparatus including a heat pump using a flammable refrigerant. Disclosed is a control method for the laundry treatment apparatus that operates a fan according to a preset time regardless of leakage of the refrigerant in order to prevent ignition of the refrigerant.

Prior art document 1 proposes a method of using the fan in order to prevent concentration of the flammable refrigerant from increasing due to leakage of the refrigerant when the flammable refrigerant is concentrated in one place. An increase in the concentration of the flammable refrigerant is prevented by operating the fan to form an internal airflow. Thereby, the possibility of ignition is lowered. Prior art document 1 discloses lowering the temperature of a compressor using a fan configured to blow air toward the compressor or to suck and then blow air around the compressor, and, at the same time, discloses using the fan in order to dilute the flammable refrigerant in the event of leakage of the flammable refrigerant (e.g., R-290).

However, the flammable refrigerant such as R-290 is characterized by high density. That is, the leaked flammable refrigerant is spread to the floor by inherent density thereof. However, since the fan in prior art document 1 is arranged in a height direction of the compressor, the farther the fan is located based on a rotational axis thereof, the less airflow is generated. Naturally, the airflow generated is likely to be insufficient to dilute the refrigerant in a lower portion of the fan.

In order to more effectively disperse the highly dense flammable refrigerant such as R-290, it is desirable to form the airflow by being concentrated in a lower part of a space. In other words, if the fan is arranged as disclosed in prior art document 1, there will be fundamental limitations in dispersing the refrigerant concentrated in the lower part of the space.

The primary function of the fan disclosed in prior art document 1 is to cool the compressor. Prior art document 1 discloses dispersing the refrigerant by generating the airflow as a method of additionally using the fan. In other words, it will be considered a normal usage environment for the fan to form the airflow capable of reaching the compressor as a whole. Concentrating the airflow in the lower portion of the compressor to form the airflow may not be considered a typical usage environment of the fan as intended by prior art document 1. Accordingly, in the laundry treatment apparatus known from prior art document 1, it is difficult to change the position of the fan in order to focus on dispersing the refrigerant spread in the lower portion of the compressor rather than cooling the compressor.

According to the disclosure of prior art document 1, there was a motivation to reduce the density of the refrigerant by generating an airflow in the laundry treatment apparatus, but the laundry treatment apparatus did not reach the level of dispersing or diluting the refrigerant spread in the lower portion of the space by concentrating the airflow in the lower part of the space.

### [Disclosure]

### [Technical Problem]

It is an object of the present disclosure to provide a structure for preventing explosion due to leakage of a flammable refrigerant in a laundry treatment apparatus equipped with a heat pump using the flammable refrigerant.

It is an object of the present disclosure to provide a structure for effectively ventilating a highly dense flammable refrigerant when the refrigerant is deposited on a lower portion of an internal space of a device, such as the floor inside a cabinet or the floor of a machine compartment.

It is an object of the present disclosure to provide an arrangement structure capable of efficiently using a limited space of a device for ventilating a flammable refrigerant.

It is an object of the present disclosure to provide disclosure is to intensively ventilate an area in which a flammable refrigerant is likely to explode due to generation of spark.

It is an object of the present disclosure to provide a low-cost, high-efficiency structure for reducing the risk of explosion in response to leakage of a flammable refrigerant.

It is an object of the present disclosure to provide a laundry treatment apparatus with an intelligent power module (IPM) temperature reduction structure to solve the problem of stopping a compressor due to an increase in the temperature of the IPM caused by an increase in power consumption of the compressor when R-290 is applied.

It is an object of the present disclosure to provide a structure for solving the problem of additional heating of an IPM due to an increased control configuration when adding a fan for cooling the IPM.

It is an object of the present disclosure to provide is a structure for providing a fan for cooling an IPM without increasing the temperature of the IPM and a fan for dispersing a refrigerant or discharging the refrigerant to the outside of a device.

It is an object of the present disclosure to provide a structure for efficiently utilizing a limited space of a machine compartment while providing a fan for discharging a leaked refrigerant.

It is an object of the present disclosure to provide a structure for reducing the size of a heat sink disposed on a control board. If the size of the heat sink is reduced, space efficiency is increased.

It is an object of the present disclosure to prevent the possibility of explosion of a refrigerant by previously operating a ventilator before operation of other electrical equipment.

It is an object of the present disclosure to effectively ventilate a leaked refrigerant by performing a safety course in which a ventilator is first operated before a main course is performed.

### [Technical Solution]

In accordance with the present disclosure, a laundry treatment apparatus includes a cabinet; a processing chamber located inside the cabinet and configured to accommodate laundry; a door configured to open and close the processing chamber; a heat exchanger located inside the cabinet, disposed in a lower portion of the processing chamber, and configured to exchange heat with air of the processing chamber using a flammable refrigerant; a control board located inside the cabinet, disposed in the lower portion of the processing chamber, and configured to control the heat exchanger; and a fan configured to cool the control board, disposed at a position adjacent to a floor inside the cabinet, and configured to disperse an airflow of the floor inside the cabinet.

In an embodiment, an exhaust port of the fan may communicate with an outside of the cabinet to discharge sucked air to the outside of the cabinet.

In an embodiment, the control board may have a mounting surface on which elements are mounted, the mounting surface facing downward, and the fan may be disposed below the control board.

In an embodiment, the laundry treatment apparatus may further include a circulation duct located inside the cabinet, disposed in the lower part of the processing chamber, and configured to form a circulation flow path that discharges air introduced from the processing chamber back to the processing chamber, and the control board may be disposed below the circulation duct.

In an embodiment, an exhaust port of the fan may communicate with the circulation duct, and air discharged from the fan may be guided to the circulation duct.

In an embodiment, a heat sink configured to cool an intelligent power module (IPM) may be disposed in the control board, and the fan may be disposed in the heat sink.

In an embodiment, the fan may be provided as a centrifugal blower or a double inlet blower.

In an embodiment, exhaust air volume of the fan may be 0.1 m³/min or more and 0.16 m³/min or less.

In an embodiment, the heat sink may include a plurality of fins arranged in a first direction, a distance between a first fin and a last fin among the plurality of fins arranged in the first direction may be smaller than a first length, the plurality of fins may extend to a second length in a second direction perpendicular to the first direction, the first length may be smaller than a diameter of a suction port of the fan, and the second length may be greater than the diameter of the suction port of the fan.

In an embodiment, the heat sink disposed in the control board may be disposed far from a compressor constituting the heat exchanger in a front-rear direction.

In an embodiment, the laundry treatment apparatus may further include a steam generator configured to generate stream from supplied water, and the steam generator may be arranged above the circulation duct.

In an embodiment, the laundry treatment apparatus may further include an outdoor air duct configured to communicate with an outside of the cabinet and the circulation duct, and an outlet port of the fan may communicate with the outdoor air duct to guide air discharged from the fan to the outdoor air duct.

In an embodiment, the circulation duct may include a chamber-side inlet port configured to communicate with the processing chamber and provided to be opened and closed, and an outdoor air-side inlet port configured to communicate with the outdoor air duct and provided to be open and closed, air discharged from the fan when the outdoor air-side inlet port is closed may be guided to an outside of the cabinet, and the air discharged from the fan when the chamber-side inlet port is closed and the outdoor air-side inlet port is opened may be guided to the circulation duct.

In an embodiment, the laundry treatment apparatus may further include a circulation fan configured to form air pressure to cause an airflow inside the circulation duct to be directed from an upstream direction to a downstream direction, and the air discharged from the fan when the chamber-side inlet port is closed and the outdoor air-side inlet port is open may be guided to the circulation duct by the air pressure.

In an embodiment the door may be provided with a first flow path configured to communicate with the outdoor air duct and an outside of the laundry treatment apparatus at a position at which the door closes the processing chamber, and a second flow path configured to communicate with the processing chamber and the outside of the laundry treatment apparatus at a position at which the door closes the processing chamber, and the air discharged from the fan when the chamber-side inlet port is closed and the outdoor air-side inlet port is opened may be guided to the circulation duct by the air pressure, flow into the processing chamber, and then flow into the outside of the cabinet through the second flow path.

In another aspect of the present disclosure, a laundry treatment apparatus includes a cabinet; a processing chamber located inside the cabinet and configured to accommodate laundry; a door configured to open and close the processing chamber; a machine compartment provided inside the cabinet and located in a lower portion of the processing chamber; a base module located in the machine compartment and configured to exchange heat with air of the processing chamber; a control board located in a control board installation portion provided in a bottom portion of the machine compartment and configured to control a configuration of the laundry treatment apparatus; and a fan disposed at a vertically overlapping position with respect to the control board and configured to discharge sucked air in a direction away from the control board.

In an embodiment, the fan may communicate with an outside of the laundry treatment apparatus to discharge the sucked air to the outside of the laundry treatment apparatus.

In an embodiment, the control board may have a mounting surface on which elements are mounted and the mounting surface may face downward

In an embodiment, the fan may be disposed below the control board.

In an embodiment, a heat sink may be disposed in the control board and the fan may be disposed at a vertically overlapping position with the heat sink.

In an embodiment, the heat sink may cool an intelligent power module (IPM) of the control board.

In an embodiment, the heat sink disposed in the control board may be disposed far from the compressor in a front-rear direction.

In an embodiment, the heat sink may include a plurality of fins arranged in a first direction with respect to the first direction and a second direction perpendicular to the first direction, a distance between a first fin and a last fin in the arranged direction may be smaller than a first length, the plurality of fins may extend to a second length in the second direction, the first length may be smaller than a diameter of a suction port of the fan, and the second length may be greater than the diameter of the suction port of the fan.

In an embodiment, the fan may be provided as a centrifugal blower.

In an embodiment, the centrifugal blower may be provided as a double inlet blower.

In an embodiment, exhaust air volume of the centrifugal blower may be 0.1 m³/min or more.

In an embodiment, exhaust air volume of the centrifugal blower may be 0.16 m³/min.

In an embodiment, the base module may include a circulation duct configured to form a circulation flow path that discharges air introduced from the processing chamber back to the processing chamber, the heat exchanger may include an evaporator disposed in the circulation flow path; a condenser disposed in the circulation flow path; a compressor disposed in the circulation flow path; and a refrigerant pipe configured to deliver a refrigerant between the condenser and the compressor, and the control board installation portion may be located in a lower portion of the circulation duct in which the evaporator and the condenser are disposed.

In an embodiment, the laundry treatment apparatus may further include a steam generator configured to generate stream from supplied water, and the steam generator may be arranged above the evaporator and the condenser.

In an embodiment, an exhaust port of the fan may communicate with the circulation duct, and air discharged from the fan may be guided to the circulation duct.

In an embodiment, the laundry treatment apparatus may further include a first filter positioned in the chamber-side inlet port; a second filter configured to divide a flow path of the circulation duct into a first circulation flow path and a second circulation flow path by separating the chamber-side inlet port into a first inlet port and a second inlet port; a first circulation flow path valve configured to open and close the first inlet port; and a second circulation flow path valve configured to open and close the second inlet port, the first circulation flow path may be a flow path through which air passing through the first inlet port is directly delivered to the evaporator and the condenser, and the second circulation flow path may be a flow path through which air passing through the second inlet port is delivered to the evaporator and the condenser via the second filter.

In an embodiment, the circulation duct may include a chamber-side inlet port configured to communicate with the processing chamber and provided upstream of the evaporator; an outdoor air-side inlet port provided upstream of the evaporator and the condenser; and an outlet port provided downstream of the evaporator and the condenser, the base module may include an outdoor air duct configured to communicate with the outdoor air-side inlet port and an exterior of the laundry treatment apparatus; a first valve configured to open and close the chamber-side inlet port; a second valve configured to open and close the outdoor air-side inlet port; and a circulation fan configured to form air pressure so that an airflow inside the circulation duct is directed from any one of the chamber-side inlet port and the outdoor air-side inlet port to the outlet port, and the outlet port of the fan may communicate with the outdoor air duct to guide air discharged from the fan to the outdoor air duct.

In an embodiment, the door may be provided with a first flow path configured to communicate with the outdoor air duct and an outside of the laundry treatment apparatus at a position at which the door closes the processing chamber, and a second flow path configured to communicate with the processing chamber and the outside of the laundry treatment apparatus at a position at which the door closes the processing chamber.

In an embodiment, the first flow path may be a path connecting a bottom surface opening provided on a bottom surface of the door and a lower portion opening provided at a position communicating with the outdoor air duct in a lower portion of a rear surface of the door.

In an embodiment, the second flow path may be a path connecting a top surface opening provided on a top surface of the door and an upper portion opening provided at a position facing an opening of the processing chamber on a rear side of the door.

In an embodiment, the laundry treatment apparatus may further include a first filter positioned in the chamber-side inlet port; a second filter configured to divide a flow path of the circulation duct into a first circulation flow path and a second circulation flow path by separating the chamber-side inlet port into a first inlet port and a second inlet port; a first circulation flow path valve configured to open and close the first inlet port; and a second circulation flow path valve configured to open and close the second inlet port, the first circulation flow path may be a flow path through which air passing through the first inlet port is directly delivered to the evaporator and the condenser, and the second circulation flow path may be a flow path through which air passing through the second inlet port is delivered to the evaporator and the condenser via the second filter.

### [Advantageous Effects]

According to various embodiments of the present disclosure, explosion due to leakage of a flammable refrigerant in a laundry treatment apparatus equipped with a heat pump using the flammable refrigerant is effectively prevented.

According to various embodiments of the present disclosure, a highly dense flammable refrigerant is effectively ventilated when the refrigerant is deposited on a lower portion of a space.

According to various embodiments of the present disclosure, as a limited space is capable of being effectively used, an additional space may not be required while providing a fan for ventilating a flammable refrigerant.

According to various embodiments of the present disclosure, an area in which a flammable refrigerant is likely to explode due to generation of spark is intensively ventilated.

According to various embodiments of the present disclosure, a low-cost, high-efficiency structure for reducing the risk of explosion in response to leakage of a flammable refrigerant is provided.

According to various embodiments of the present disclosure, the problem of stopping a compressor due to an increase in the temperature of an intelligent power module (IPM) caused by an increase in power consumption of the compressor when R-290 is applied is solved.

According to various embodiments of the present disclosure, since a control configuration is not increased, overheating of an IPM is prevented while providing a fan for cooling the IPM and a fan for discharging a leaked refrigerant.

According to various embodiments of the present disclosure, a space is efficiently utilized while providing a fan for discharging a leaked refrigerant.

According to various embodiments of the present disclosure, a fan is mounted directly in a control box in which ignition points are located, and thus the fan is safer and a course time is reduced.

According to various embodiments of the present disclosure, a structure for reducing the size of a heat sink disposed on a control board is provided. If the size of the heat sink is reduced, space efficiency is increased.

According to various embodiments of the present disclosure, the possibility of explosion of a refrigerant is prevented by operating a ventilator before operation of other electrical equipment.

According to various embodiments of the present disclosure, a leaked refrigerant is effectively ventilated by performing a safety course in which a ventilator is first operated before a main course is performed.

### [Description of Drawings]

FIG. 1 is a perspective view illustrating the outer appearance of a laundry treatment apparatus according to an embodiment of the present disclosure;
FIG. 2 is a perspective view illustrating an open state of a door 20 of the laundry treatment apparatus 1 according to the embodiment of the present disclosure;
FIG. 3 illustrates an embodiment of various configurations located in a machine compartment;
FIG. 4 is a perspective view of a base module 1000 according to an embodiment of the present disclosure;
FIGS. 5 and 6 are diagrams illustrating a heat exchanger 700 provided in the base module 1000;
FIG. 7 is a diagram illustrating a control board installation portion 360;
FIG. 8 illustrates the control board installation portion 360 in which the blower 400 is removed for a detailed description of the control board installation portion 360;
FIG. 9 is a diagram illustrating the control box 600 installed in the control board installation portion 360;
FIG. 10 is a diagram of a base portion 300 viewed from the rear to explain the control box 600 installed in the control board installation portion 360;
FIG. 11 is a cross-sectional perspective view of the control board installation portion 360 in which the base portion 300 is not shown;
FIGS. 12 and 13 are diagrams illustrating a coupling relationship between a fan 800, a control box 600, and an outdoor air duct 340;
FIG. 14 is a diagram illustrating the arrangement of the fan 800 in the control box 600;
FIG. 15 is a diagram illustrating a relationship between the heat sink 620 and the fan 800 according to an embodiment;
FIG. 16 is a diagram illustrating an airflow discharge structure by the fan 800;
FIG. 17 is a diagram illustrating a refrigerant discharge path in a stream-using course;
FIG. 18 is a diagram illustrating a refrigerant discharge path in a drying course;
FIG. 19 is a diagram illustrating a refrigerant discharge path in an indoor dehumidification course;
FIG. 20 is a diagram illustrating a refrigerant discharge path in a non-course;
FIG. 21 is an experimental graph for confirming a refrigerant discharge effect, illustrating refrigerant concentration near a control board 610; and
FIG. 22 is an experimental graph for confirming the refrigerant discharge effect as a graph measuring refrigerant concentration in a central portion and the second opening 32 of the processing chamber 35 when the laundry treatment apparatus 1 operates in an indoor dehumidification course.

### [Best Mode]

Reference will now be made in detail to the exemplary embodiments of the present disclosure, examples of which are illustrated in the accompanying drawings. A construction or a control method of an apparatus to be described below describes embodiments of the present disclosure only and is not intended to limit the scope of the present disclosure. Wherever possible, the same reference numbers will be used throughout the drawings to refer to the same or like parts.

Specific terms used in the present specification are only for convenience of description and do not limit exemplified embodiments.

For example, expressions such as "same" and "identical" not only indicate the strictly identical state but also indicate a state in which a tolerance or a difference in the degree of obtaining the same function exists.

In this specification, it should be understood that, when an element is referred to as being "connected to" or "coupled to" another element, the element may be directly connected to or coupled to the other element or an intervening element may also be present therebetween. In contrast, it should be understood that, when an element is referred to as being "directly connected to" or "directly coupled to" another element, no intervening elements are present.

In this specification, terms such as "include" or "has" are intended to indicate the presence of features, numbers, steps, operations, elements, components, or combinations thereof used herein and it should be thus understood that the possibility of presence or addition of one or more different features, numbers, steps, operations, elements, components, or combinations thereof is not excluded.

For example, expressions indicating relative or absolute arrangement, such as "in a certain direction", "along a certain direction", "in parallel to", "orthogonal to", "centering on", "concentrically to", and "coaxially to" not only strictly indicate such an arrangement but also indicate a state in which a relative displacement is carried out with a tolerance or an angle or a distance sufficient to obtain the same function.

The present disclosure will be described based on a spatial orthogonal coordinate system with an X-axis, a Y-axis, and a Z-axis orthogonal to each other. Each axis direction (X-axis direction, Y-axis direction, or Z-axis direction) refers to both directions in which each axis extends. Each axis direction with a '+' sign in front thereof (+X-axis direction, +Y-axis direction, or +Z-axis direction) refers to a positive direction which is one of the two directions in which each axis extends. Each axis direction with a '-' sign in front thereof (-X-axis direction, -Y-axis direction, and -Z-axis direction) refers to a negative direction which is the other of the two directions in which each axis extends.

Expressions used herein to indicate directions such as "front (+Y)", "back (-Y)", "left (+X)", "right (-X)", "up (+Z)", and "down (-Z)" are defined by the X, Y, and Z coordinate axes, but these expressions are merely used for better understanding of the present disclosure. That is, it is obvious that the directions may be defined differently depending on where the reference is placed.

The use of terms such as "first", "second", "third", etc. in front of the components described herein is only to avoid confusion between the components. That is, the terms are not related to the order, importance, or master-slave relationship between the components. For example, an embodiment including only a second component without a first component is also feasible.

The singular form used herein includes plural forms unless the context clearly dictates otherwise.

In this specification, the term "and/or" includes any and all combinations of one or more of the associated listed items. In this specification, "A or B" may include "A", "B", or "both A and B".

### <Embodiment of the outer appearance of a laundry treatment apparatus 1>

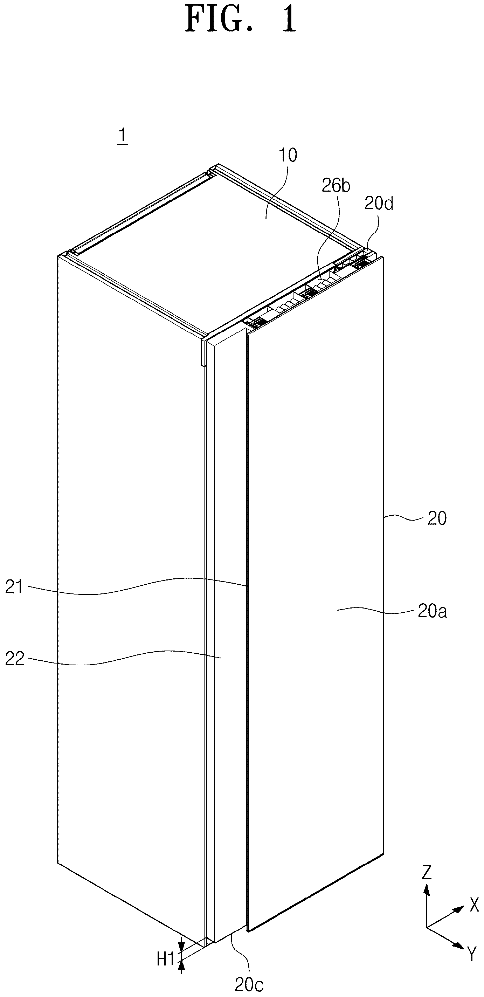

FIG. 1 is a perspective view illustrating the outer appearance of a laundry treatment apparatus 1 according to an embodiment of the present disclosure. The outer appearance of the laundry treatment apparatus 1 according to an embodiment will now be described with reference to FIG. 1.

A cabinet 10 forms the outer appearance of the laundry treatment apparatus 1. The cabinet 10 may be provided to have height that is longer than width (width in a left-right direction) and thickness (width in a front-back direction).

A door 20 is located at the front of the laundry treatment apparatus 1. The door 20 is coupled to the front side of the cabinet 10. In an embodiment, the door 20 is hinged to the cabinet 10. A front surface 21a of the door 20 may be provided with a handle 21 and a manipulation portion 22. A display that displays information about the laundry treatment apparatus 1 may be installed on the manipulation portion 22 .

A bottom surface 20c of the door 20 according to the embodiment is installed to be spaced apart from the floor by a set height H1. As the bottom surface 20c of the door 20 is spaced apart from the floor (installation surface), outdoor air may flow into the laundry treatment apparatus 1 through a door bottom surface opening formed in the bottom surface 20c of the door 20, which will be described later.

A top surface opening 26b is formed in a top surface 20d of the door 20 according to the embodiment.

### <Open state of processing chamber 35 by opening door 20>

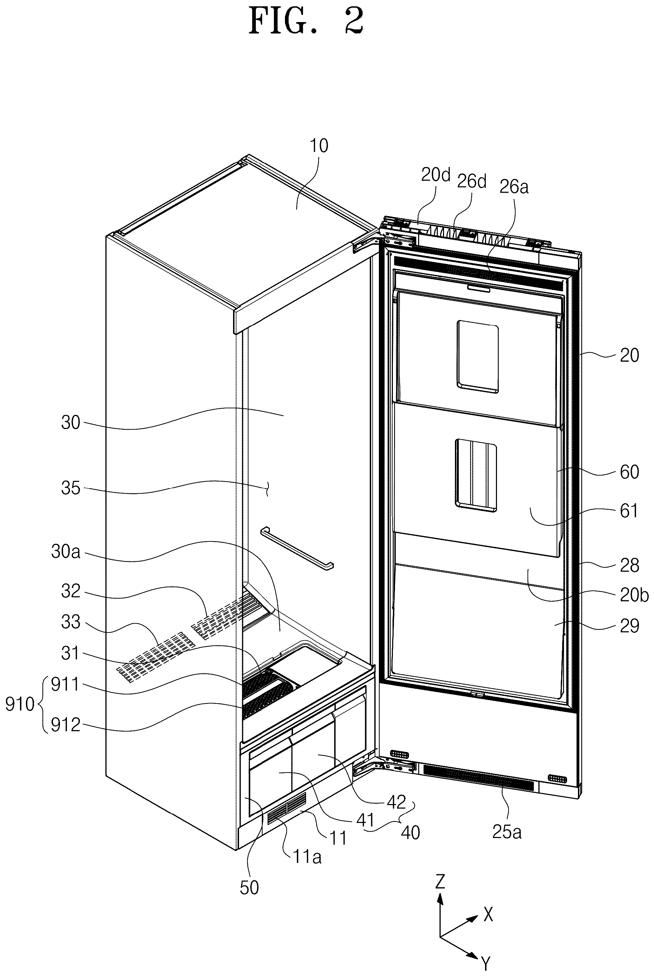

FIG. 2 is a perspective view illustrating an open state of the door 20 of the laundry treatment apparatus 1 according to an embodiment of the present disclosure. The interior of the laundry treatment apparatus 1 exposed to a user when the door 20 is opened will now be described with reference to FIG. 2.

An inner case 30 accommodates laundry and forms a processing chamber 35, which is a space in which laundry is treated. The inner case 30 is located inside the cabinet 10. The front of the inner case 30 is open to form an opening through which laundry is inserted. The front of the inner case 30 is open so that laundry is inserted, thereby forming an opening. The inner case 30 may be provided to have height longer than width and thickness. As a result, laundry may be placed inside the processing chamber 35 without being folded or wrinkled. The inner case 30 may be made of a plastic resin series and may be made of a reinforced plastic resin series that is not deformed by air at a temperature higher than air of room temperature, heated air (hereinafter referred to as hot air), steam, or moisture.

An upper inner surface of the inner case 30 may be provided with a laundry holder (not shown) for holding laundry in the processing chamber 35. The laundry holder may be provided in the shape of a hanger and may be fixed to the upper surface of the inner case 30. Due to the laundry holder, laundry may be placed in an unfolded state within the processing chamber 35. The laundry holder may be provided as a hanger that reciprocates in a width direction or rotatably reciprocates within the inner case 30. The laundry treatment apparatus 1 according to the embodiment may shake laundry inside the inner case 30 using the laundry holder. When shaking laundry, foreign substances and dust may be removed from the laundry, and wrinkles on the laundry may also be removed.

The height of the processing chamber 35 is lower than the overall height of the cabinet 10. A lower portion of the processing chamber 35 is provided with a machine compartment. The processing chamber 35 and the machine compartment may be separated and partitioned by the inner case 30 of a floor portion 30a of the processing chamber 35.

Various devices are installed in the machine compartment. The various devices installed in the machine compartment may include a device that supplies heated air (hereinafter referred to as hot air) to the processing chamber 35, a device that supplies steam to the processing chamber 35, and a device that purifies or dehumidifies the outdoor air of the cabinet 10. The various devices provided in the machine compartment will be described in detail later.

A plurality of openings may be formed in the wall of the inner case 30 defining the processing chamber 35 to communicate with the machine compartment. In the embodiment, the plurality of openings may be formed in the floor portion 30a. In the embodiment, air of the processing chamber 35 may move to the machine compartment through the openings, and one or more of hot air and steam generated in the machine compartment may move to the processing chamber 35.

In the embodiment, a first opening 31, a second opening 32, and a third opening 33 may be formed in the inner case 30.

The first opening 31 is a passage through which air inside the inner case 30 flows toward the machine compartment. The first opening 31 communicates with a chamber-side inlet port 324 of a circulation duct 320, which will be described later. The first opening 31 may be disposed toward the front of a lower surface of the inner case 30.

The second opening 32 is a passage through which air supplied from the machine compartment flows towards the inner case 30. The second opening 32 communicates with an air blowing outlet port 401 described later. The second opening 32 may be disposed toward the rear of the lower surface of the inner case 30. As the first opening 31 is formed towards the front and the second opening 32 is formed towards the rear, a separation distance between the first opening 31 and the second opening 32 may be secured, and air supplied to the processing chamber 35 through the second opening 32 may be prevented from being discharged directly through the first opening 31.

The third opening 33 is a passage through which steam supplied from the machine compartment flows towards the inner case 30. The third opening 33 communicates with a steam nozzle 510 which will be described later. The third opening 33 may be disposed closer to the second opening 32 than to the first opening 31. In the embodiment, the third opening 33 may be disposed in a lateral direction of the second opening 32. As a separation distance between the third opening 33 and the first opening 31 is secured, the steam discharged through the third opening 33 may be prevented from being discharged through the first opening 31.

A water supply and drainage tank 40 may be disposed in a lower portion of the processing chamber 35. The water supply and drainage tank 40 may be disposed in the front of the machine compartment. The water supply and drainage tank 40 may be disposed at a position exposed to the user when the door 20 is opened.

The water supply and drainage tank 40 may be composed of a water supply tank 41 and a drainage tank 42. The water supply tank 41 is a tank that stores water in order to supply moisture to the processing chamber 35. The drainage tank 42 is a tank that collects water condensed inside the laundry treatment apparatus 1.

A water tank holder 50 is configured to support the water supply and drainage tank 40. The water tank holder 50 is disposed in the front of the machine compartment and may prevent the machine compartment from being exposed to the outside. The water supply and drainage tank 40 may be attached to and detached from the water tank holder 50. The water tank 41 and the water tank 42 may be separated from the water tank holder 50. The user may separate the water supply and drainage tank 40 from the water tank holder 50 to fill the water tank 41 with water and discard water collected in the water tank 42.

A lower portion opening 11a may be located below the water tank holder 50. The lower portion opening 11a may be formed on a lower front panel 11. The lower front panel 11 may be located below the water tank holder 50. The lower front panel 11 may be located below the water tank holder 50 among panels forming the cabinet 10. The lower portion opening 11a communicates with an outdoor air hole 345 of an outdoor air duct 340 which will be described later.

A gasket 28 may be installed on the periphery of a rear surface 20b of the door 20. When the door 20 is closed, the gasket 28 may be in close contact with the periphery of the processing chamber 35 to seal the processing chamber 35.

When the door 20 is closed, the rear surface 20b of the door 20 may be formed with a protruding condensate water guider 29 that may be inserted into the inside of the processing chamber 35. The condensate water guider 29 may be provided with width corresponding to the width of an opening of the processing chamber 35. The condensate water guider 29 may be disposed close to the floor portion 30a of the processing chamber 35. The condensate water guider 29 guides moisture flowing along the wall of the door 20 to the floor portion 30a of the processing chamber 35, thereby preventing moisture from flowing into the machine compartment.

A door lower portion opening 25a is formed in a lower portion of the rear surface 20b of the door 20 according to the embodiment. The door lower portion opening 25a communicates with a door bottom surface opening formed in the bottom surface of the door 20 to form a first flow path through which air passes into the interior of the door. The door lower portion opening 25a faces the lower portion opening 11a in a state in which the door 20 is closed. The door lower portion opening 25a communicates with the lower portion opening 11a in a state in which the door 20 is closed.

A door upper portion opening 26a is formed in the rear surface 20b of the door 20 according to the embodiment. The door upper portion opening 26a communicates with the door top surface opening 26b formed in the top surface 20d of the door 20 to form a second flow path through which air passes into the interior of the door. The door upper portion opening 26a faces the processing chamber 35 in a state in which the door 20 is closed. The door upper portion opening 26a communicates with the processing chamber 35 in a state in which the door 20 is closed. The door upper portion opening 26a may be located at a portion corresponding to an upper portion of the processing chamber 35.

In the embodiment, the rear surface 20b of the door 20 may include a laundry pressurizing device 60 capable of pressurizing laundry and a supporter 65 provided above the laundry pressurizing device 60 to support hanging laundry. The supporter 65 according to the embodiment may be provided in the form of a ring on which a laundry hanger may be hung. The laundry pressurizing device 60 according to the embodiment may pressurize laundry hanging on the supporter 65 using a pressurizing plate 61 that pivots. Laundry hanging on the supporter 65 is pressurized by the laundry pressurizing device 60, so that wrinkles may be removed or intended wrinkles may be formed.

### <Embodiment of various configurations located in machine compartment>

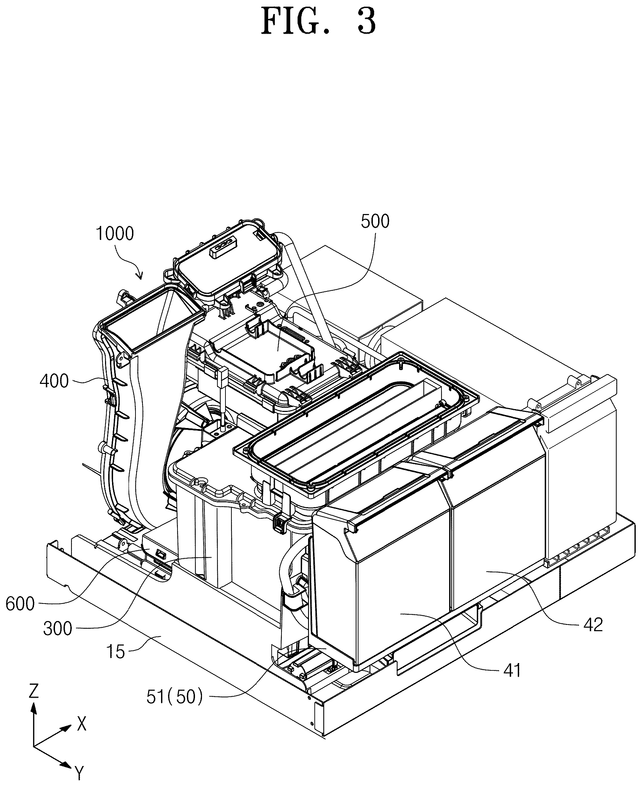

FIG. 3 is a diagram for explaining an embodiment of various configurations located in a machine compartment.

The machine compartment is located at an upper portion of a cabinet floor plate 15. Various mechanical devices located in the machine compartment will now be described with reference to FIG. 3.

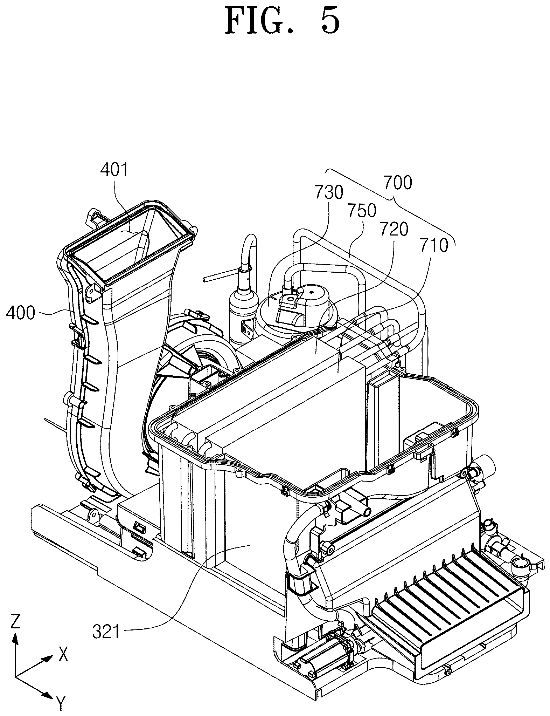

A base module 1000 is installed in the machine compartment. The base module 1000 according to the embodiment may be provided as a module including a blower 400, a steam generator 500, a control box 600, and a heat exchanger 700 (see FIG. 5).

The base module 1000 includes a base portion 300. The base portion 300 provides a space in which each device is installed and may function as a support for supporting various devices. Further, the base portion 300 itself may function as a duct.

The water supply and drainage tank 40 may be located at the front of the base module 1000. The base module 1000 may be located at the rear of the water supply and drainage tank 40. The base module 1000 may be hidden without being exposed to the outside by the water tank holder 50 in which the water supply and discharge tank 40 is installed. FIG. 3 shows a water tank support plate 51 which is a part of the water tank holder 50.

### <Embodiment of base module 1000>

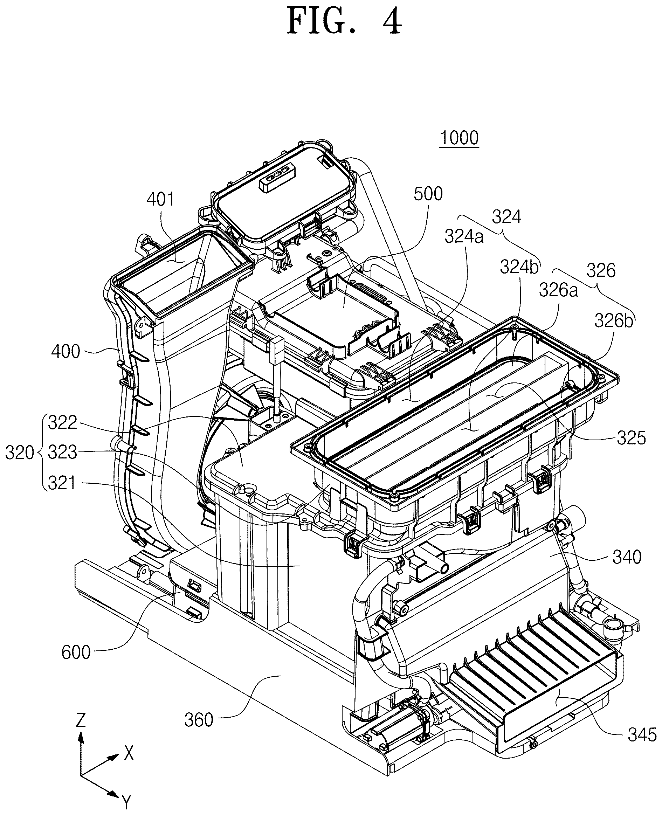

FIG. 4 is a perspective view of the base module 1000 according to an embodiment of the present disclosure. The base module 1000 will now be described in more detail with reference to FIG. 4 .

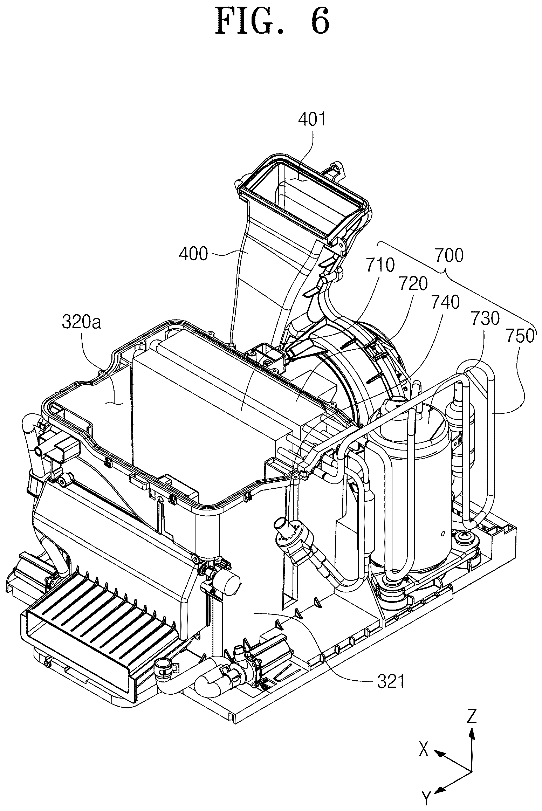

The base portion 300 is provided with a circulation duct 320. The circulation duct 320 may be formed by the base portion 300. The circulation duct 320 forms a circulation flow path 320a (see FIG. 6) through which air moves.

The base portion 300 may include a duct body 321, a duct cover 322, and a duct inlet 323 that constitute the circulation duct 320. According to the embodiment, the duct inlet 323 is formed on the duct cover 322. The duct inlet 323 may be formed to protrude upward from the duct cover 322. The duct body 321 forms a space in which an upper portion thereof is open. An open top surface of the duct body 321 is covered by the duct cover 322.

A chamber-side inlet port 324 is formed in the duct inlet 323. The chamber-side inlet port 324 may include a first inlet port 324a and a second inlet port 324b. The first inlet port 324a and the second inlet port 324b may be separated by a second filter installation portion 325.

In the embodiment, a first valve 326 is installed at the chamber-side inlet port 324. The first valve 326 opens and closes the chamber-side inlet port 324. The first valve 326 may include a first circulation flow path valve 326a and a second circulation flow path valve 326b. The first circulation flow path valve 326a opens and closes the first inlet port 324a. The second circulation flow path valve 326b opens and closes the second inlet port 324b.

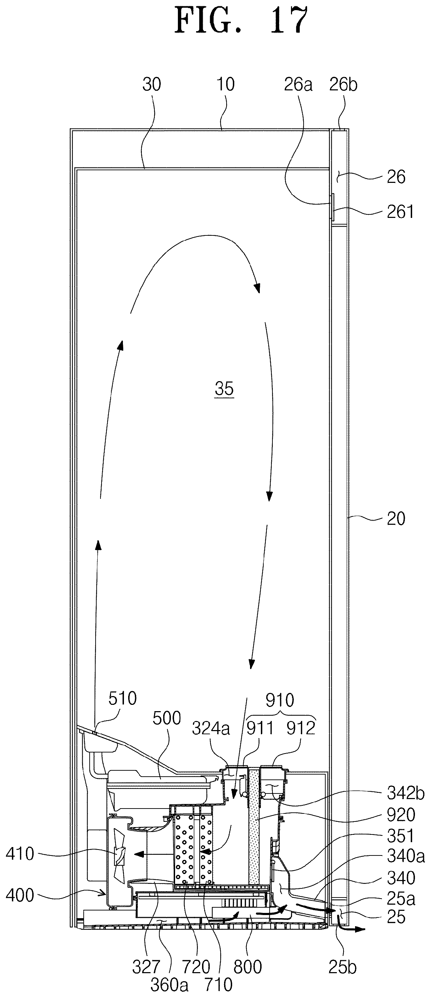

A first filter 910 (see FIG. 17) is disposed at the chamber-side inlet port 324. The first filter 910 may include a first inlet port filter 911 and a second inlet port filter 912. The first inlet port filter 911 is disposed at the first inlet port 324a. The second inlet port filter 912 is disposed at the second inlet port 324b. The first inlet port filter 911 and the second inlet port filter 912 may be removed from the device by the user and cleaned or replaced.

A control board installation portion 360 may be provided at a lower portion of the duct body 321. The control box 600 is installed in the control board installation portion 360. The control board installation portion 360 and the control box 600 will be described in detail later.

The blower 400 is installed at the rear of the duct body 321. The blower 400 forms air pressure that creates an air flow flowing through the circulation flow path 320a. The blower 400 forms an airflow so that air of the circulation flow path 320a is discharged to the air blowing outlet port 401.

The steam generator 500 generates steam with water supplied from the water tank 41. The steam generator 500 may be supported on the base portion 300. The steam generator 500 may be located at a top surface of the duct cover 322. The steam nozzle 510 is configured to discharge steam generated by the steam generator 500. Since AC current is supplied to the steam generator 500, there is a risk of explosion due to spark generation when the current comes into contact with a leaking refrigerant. Since the leaking refrigerant has high density and sinks to the floor, the steam generator 500 may be advantageously disposed at the top. In the embodiment, the steam generator 500 is located above the heat exchanger 700.

One end of the outdoor air duct 340 is connected to the circulation duct 320, and an outdoor air inlet port 345, which is the other end of the outdoor air duct 340, leads to the outside. The outdoor air duct 340 is configured to communicate with outdoor air and the circulation duct 320. The outdoor air inlet port 345 faces the lower portion opening 11a of the lower front panel 11 and may communicate with outdoor air.

### <Embodiment of heat exchanger 700>

FIGS. 5 and 6 are diagrams illustrating the heat exchanger 700 provided in the base module 1000.

The heat exchanger 700 according to an embodiment includes an evaporator 710, a condenser 720, and a compressor 730. The heat exchanger 700 may further include an expansion valve 740 and a refrigerant pipe 750 connecting the expansion value 740.

The evaporator 710 and the condenser 720 are located in the circulation flow path 320a, which is inside the circulation duct 320. In the embodiment, the compressor 730 and the expansion valve 740 are located outside the circulation duct 320.

The evaporator 710 cools and condenses air. The compressor 730 receives a refrigerant from the evaporator 710, and compresses and heats the refrigerant. The condenser 720 receives the refrigerant from the compressor 730 and heats air. The expansion valve 740 expands the refrigerant that has passed through the condenser 720 to lower the temperature of the refrigerant. The refrigerant may be a refrigerant with a low GWP index, such as R-290. The refrigerant may be flammable.

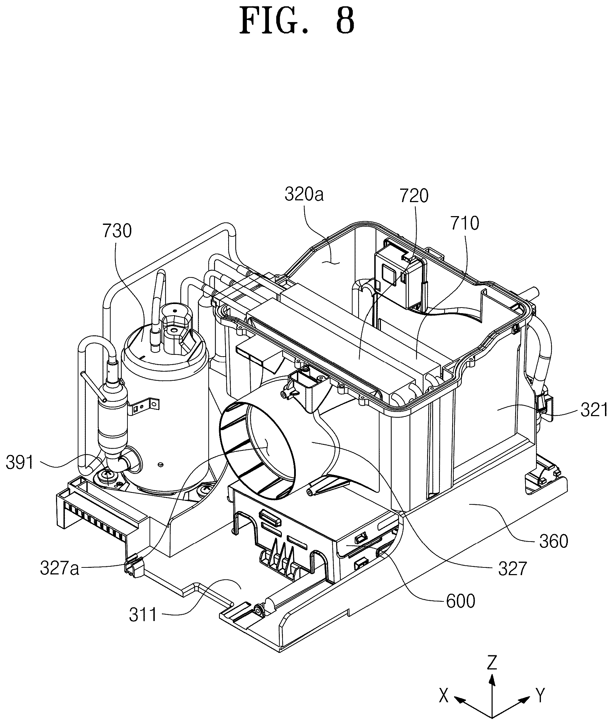

Air in the processing chamber 35 flows into the circulation flow path 320a through the chamber-side inlet port 324. The air flows along the circulation flow path 320a from the chamber-side inlet port 324 and passes through the evaporator 710 and the condenser 720. The evaporator 710 cools and dehumidifies the air flowing through the circulation flow path 320a. The condenser 720 heats the air that has passed through the evaporator 710 to form hot air. An outlet port 327a (see FIG. 8) of the duct body 321 is located downstream of the condenser 720. The outlet port 327a may be defined by an outlet duct 327.

The blower 400 forms air pressure so that an airflow inside the circulation duct 320 is directed toward the outlet port 327a. The air dehumidified and heated in the circulation flow path 320a passes through the outlet port 327a along the airflow formed by the blower 400 and is discharged to the air blowing outlet port 401.

### <Embodiment of control board installation portion 360>

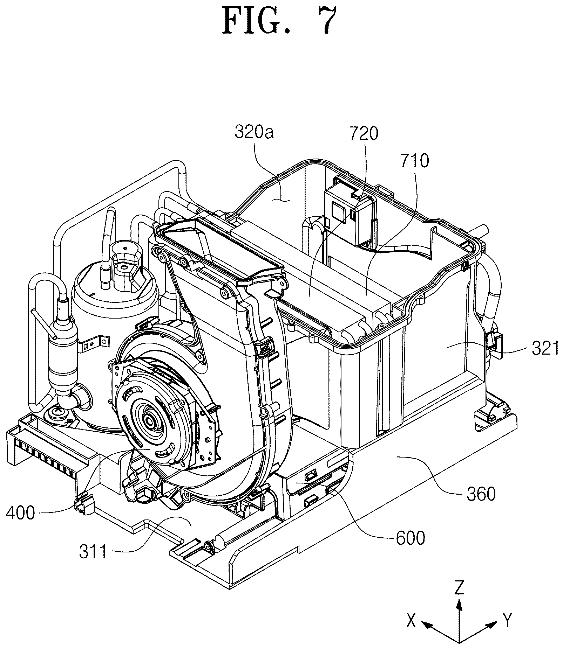

FIG. 7 is a diagram illustrating the control board installation portion 360. FIG. 8 illustrates the control board installation portion 360 in which the blower 400 is removed for detailed illustration of the control board installation portion 360.

The control box 600 is installed in the control board installation portion 360. The control box 600 may supply power to various components constituting the laundry treatment apparatus 1, such as the heat exchanger 700, the steam generator 500, the blower 400, and a fan 800. Alternatively, the control box 600 controls various components constituting the laundry treatment apparatus 1, such as the heat exchanger 700, the steam generator 500, the blower 400, and the fan 800. The control box 600 is configured to control all electronically controlled components such as the heat exchanger 700, the steam generator 500, and the blower 400, and may perform various courses and options for treating laundry.

In the embodiment, the control board installation portion 360 is located below the duct body 321. In the embodiment, the control board installation portion 360 may be provided between a base floor portion 311 and the duct main body 321. The control board installation portion 360 may be provided at a lower portion of the circulation duct 320 in which the evaporator 710 and the condenser 720 are disposed.

The control board installation portion 360 is located at a bottom portion of the machine compartment. The control board installation portion 360 may be provided in an open duct shape at any one of the front and the rear. The control board installation portion 360 is provided with an installation space 360a into which the control box 600 may be inserted.

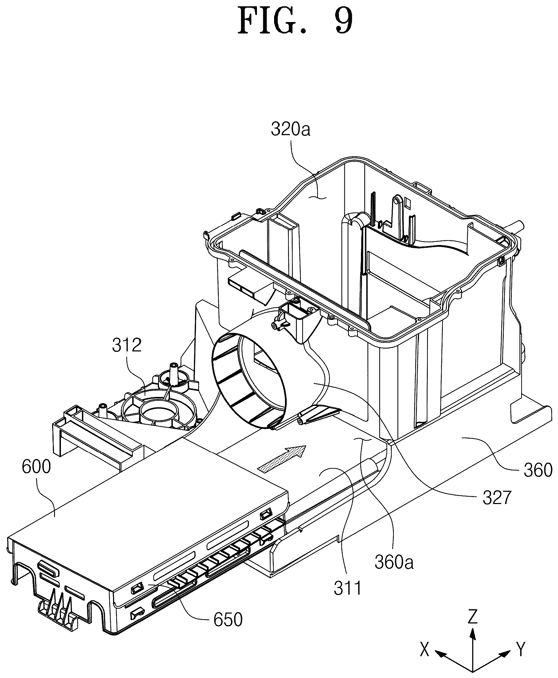

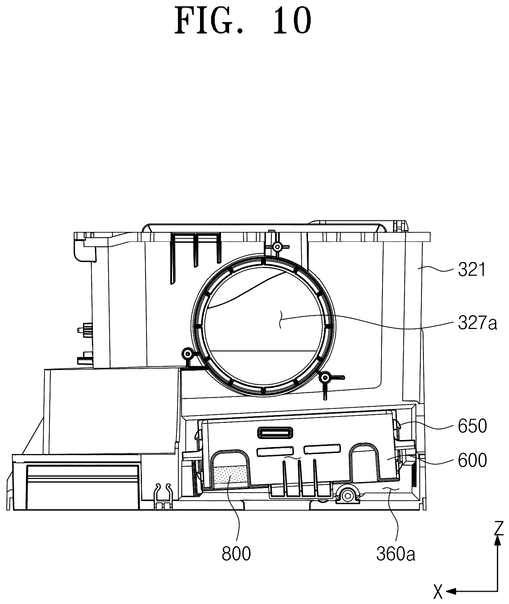

FIG. 9 is a diagram illustrating the control box 600 installed in the control board installation portion 360. FIG. 10 is a diagram of the base portion 300 viewed from the rear to explain the control box 600 installed in the control board installation portion 360. The control box 600 installed in the control board installation portion 360 will now be described with reference to FIGS. 9 and 10.

The control board installation portion 360 is disposed in a lower portion of the duct body 321 constituting the circulation duct 320. The floor of the duct body 321 may form a top surface of the control board installation portion 360. The control board installation portion 360 may be formed integrally with the base floor portion 311.

The control box 600 is inserted into the control board installation portion 360 and is supported on the upper portion of the control board installation portion 360. The control box 600 is spaced apart from the base floor portion 311. The control box 600 may be inserted in a slide manner from the rear of the control board installation portion 360 toward the front thereof.

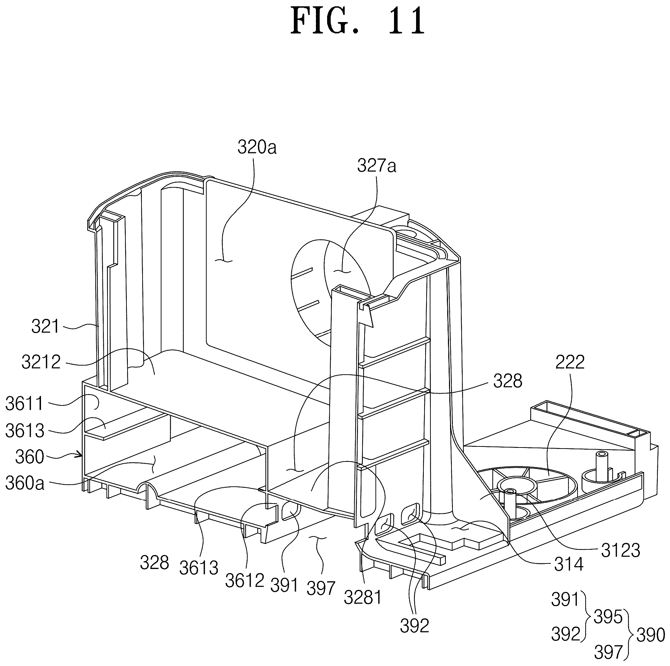

The control box 600 may further include a bracket 650 surrounding a control board 610. The bracket 650 forms the periphery of the control box 600 and may prevent foreign substances from entering the control board 610. The bracket 650 may be made of a metal material. The control box 600 may be supported and seated on the control board installation portion 360 by the bracket 650. The control box 600 may be supported on the control board installation portion 360 by mutual coupling of a protrusion formed on the bracket 650 and a protrusion 3613 (see FIG. 11) protruding from the control board installation portion 360.

The control box 600 may be installed at an inclination relative to the base floor portion 311. For example, the control box 600 may have a greater separation distance from the base floor portion 311 on the outside than on the inside. As the control box 600 is slanted, when water leaks into the upper portion of the control box 600, the water may quickly exit the control box 600.

FIG. 11 is a cross-sectional perspective view of the control board installation portion 360 in which the base portion 300 is not shown.

External power may be supplied to operate each component of the laundry treatment apparatus 1. The external power may be supplied through AC or high voltage DC. In this case, there is a possibility of ignition due to arcing at an AC or high voltage DC terminal. If a refrigerant such as R-290 is maintained at a certain concentration or more, there is a risk of ignition occurring in the control box 600. Therefore, it is important to ventilate the inside of the control board installation portion 360 to ensure the stability of a laundry treatment apparatus using a flammable refrigerant. In the case of a conventional laundry treatment apparatus, the control box is arranged in an upper portion of the cabinet. Therefore, even if R-290 of high density has been used, the possibility of ignition of the flammable refrigerant in the control box was not high. In the laundry treatment apparatus 1 according to the embodiment of the present disclosure, the control board installation portion 360 and the control box 600 are disposed in the lower portion of the laundry treatment apparatus. Therefore, if the flammable refrigerant leaks, there is a high possibility that the flammable refrigerant will ignite in the control box 600.

The base portion 300 may include the control board installation portion 360. The control box 600 is installed in the control board installation portion 360. The control box 600 is provided with the control board 610.

The control board installation portion 360 is located inside the cabinet 10 and may be disposed below the processing chamber 30. In the embodiment, the control board installation portion 360 may be disposed below the duct body 321. A floor surface 3212 of the duct body 321 forming the floor of the circulation flow path 320a may form the top surface of the control board installation portion 360.

Among partition walls 3611 and 3612 forming both sides of the control board installation portion 360 in a width direction, the partition wall 3611 forming one side of the control board installation portion 360 may form an outer wall of the base portion 300. Support protrusions 3613 for supporting the control box 600 may be formed on the partition walls 3611 and 3612 of the control board installation portion 360 in a width direction.

In the embodiment, a ventilation hole 395 may be formed in a lower portion of the base portion 300. The ventilation hole 395 may ventilate lower air of the base portion 300. The ventilation hole 395 may be formed in the partition walls 3611 and 3162 and may be formed appropriately in a place in which ventilation of the refrigerant is required.

A bypass flow path 397 may be formed in the base portion 300. The bypass flow path 397 may be disposed on a bottom surface of the base portion 300. The bypass flow path 397 may form a ventilation flow path 390 together with the ventilation hole 395. The bypass flow path 397 may be located below the circulation flow path 320a. The floor surface of the circulation flow path 320a may form a top surface of the bypass flow path 397.

A control portion penetration hole 391 may be formed in the partition wall 3612 toward the bypass flow path 397 among both sides of the control board installation portion 360.

One side of the base portion 300 located close to a compressor installation portion 312 is provided with a pipe arrangement portion 314 in which the refrigerant pipe 750 and the expansion valve 740 of the heat exchanger 700 are disposed. The circulation flow path 320a may be disposed biased to one side of the base portion 300 in a width direction. The pipe arrangement portion 314 may be disposed on the other side of the base portion 300 in the width direction. That is, the pipe arrangement portion 314 may be disposed on one side of the circulation flow path 320a.

The ventilation hole 395 may include a pipe-side through hole 392 formed in a partition wall forming the bypass flow path 397. The pipe-side through hole 392 may form a fluid path that may flow to an upper portion of the base portion 300 and the bottom surface of the base portion 300. A refrigerant or air accumulated on a top surface of the base portion 300 may move to the bottom surface of the base portion 300 through the pipe-side through hole 392. According to the embodiment, the flammable refrigerant deposited on the pipe arrangement portion 314 may be ventilated through the bottom surface of the base portion 300 using the pipe-side through hole 392. The refrigerant moves downward due to high density thereof. The pipe-side through hole 392 functions as a path capable of effectively discharging the refrigerant that has moved from the upper side to the lower side.

The duct body 321 may include the heat exchanger 700 and a water collection portion 328 in which water condensed in the evaporator 710 is stored. The water collection portion 328 may be formed by stepping down a portion of the floor surface 3212 of the circulation duct 320. A water collection floor surface 3281, which is a floor surface of the water collection portion 328, may form a top surface of the bypass flow path 397. The bypass flow path 397 may be formed on a lower side of the water collection floor surface 3281. An upper portion of the water collection floor surface 3281 may form the circulation duct 320, and a lower portion thereof may form a bottom surface of the base portion 300.

### <Fan 800 for discharging refrigerant and cooling control box 600>

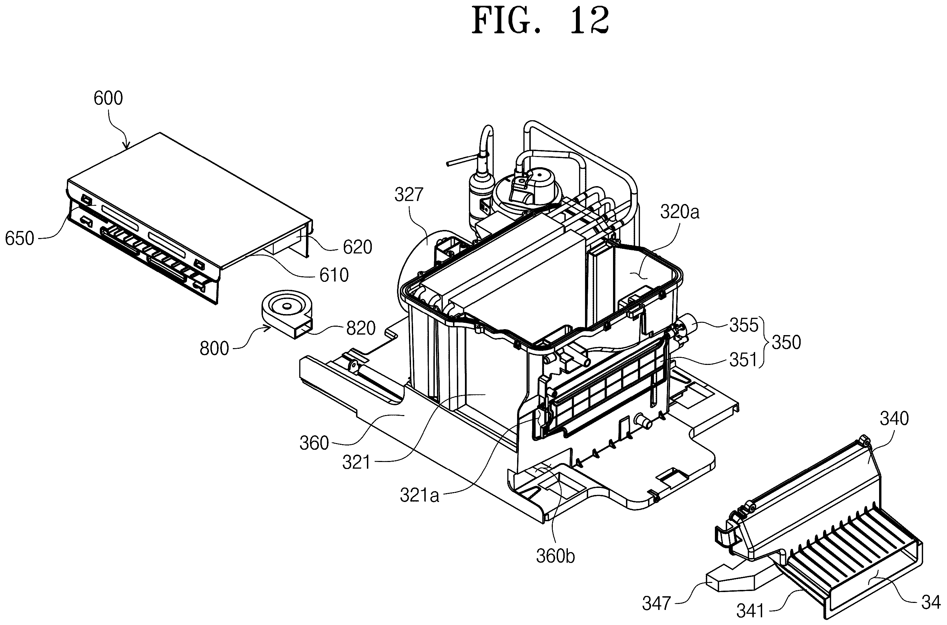

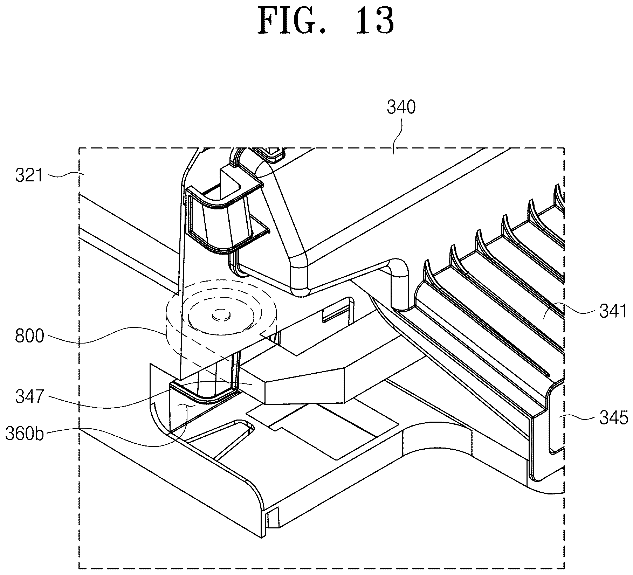

FIGS. 12 and 13 are diagrams illustrating a coupling relationship between the fan 800, the control box 600, and the outdoor air duct 340. A location at which the fan 800 is installed will now be described with reference to FIGS. 12 and 13 .

The control board 610 is provided with the control box 600. The bracket 650 may surround the periphery of the control board 610. The fan 800 may be located in the control box 600. The fan 800 may be disposed at a vertically overlapping position with respect to the control board 610. The fan 800 cools elements of the control board 610. The fan 800 is disposed at a position adjacent to the floor inside the cabinet 10. The fan 800 is disposed below the control board 610. The fan 800 discharges sucked air in a direction away from the control board 610. The fan 800 disperses an airflow of the floor of the machine compartment. That is, when the flammable refrigerant leaks, the fan 800 disperses the flammable refrigerant concentrated on the floor due to high density thereof. The fan 800 serves to lower the concentration of the flammable refrigerant concentrated on the floor. If the fan 800 lowers the concentration of the flammable refrigerant below a lower explosion limit, the possibility of explosion becomes very low.

The fan 800 is provided as a centrifugal blower. According to the embodiment, the fan 800 is provided as a double inlet blower.

An outdoor air-side inlet port 321a is formed in the front of the duct body 321 in the base portion 300. The outdoor air-side inlet port 321a is located upstream of the evaporator 710 and the condenser 720 in the circulation flow path 320a. The outdoor air-side inlet port 321a may be formed in a rectangular shape. The outdoor air-side inlet port 321a may be opened and closed by a second valve 350. The second valve 350 may include a second valve plate 351 and a valve driving source 355 that provides power for switching the position of the second valve plate 351 between an open position and a closed position. In the embodiment, the second valve 350 may open or close the outdoor air-side inlet port 321a by driving the second valve plate 351 to rotate about a rotation axis.

The outdoor air duct 340 is configured to communicate with the outdoor air-side inlet port 321a and the outside of the laundry treatment apparatus 1. One side of the outdoor air duct 340 is in contact with the circulation duct 320. One side of the outdoor air duct 340 is arranged to communicate with the outdoor air-side inlet port 321a. The outdoor air inlet port 345 is formed on the other side of the outdoor air duct 340, and the outdoor air inlet port 345 is in contact with a side connected to the outside.

In the embodiment, the fan 800 communicates with the outside of the laundry treatment apparatus 1 to discharge sucked air to the outside of the laundry treatment apparatus 1. In the embodiment, the fan 800 is connected to the outdoor air duct 340. In the embodiment, the outdoor air duct 340 includes an external communication portion 341 and a fan communication portion 347. The fan communication portion 347 is a duct extending in a direction toward the fan 800. The fan communication portion 347 and the external communication portion 341 communicate with each other. An exhaust port 820 of the fan 800 may be connected to the fan communication portion 347 to communicate with the outdoor air flow path 340a of the outdoor air duct 340.

An installation portion front opening 360b may be formed in the front of the control board installation portion 360 in the base portion 300. The fan communication portion 347 extends toward the installation portion front opening 360b. The exhaust port 820 of the fan 800 is positioned toward the installation portion front opening 360b. The exhaust port 820 of the fan 800 and the fan communication portion 347 are connected to each other through the installation portion front opening 360b. Air discharged through the exhaust port 820 of the fan 800 is guided to pass through the fan communication portion 347. The air that has passed through the fan communication portion 347 is guided to the outdoor air flow path 340a of the outdoor air duct 340.

When the second valve 350 is at a position to open the outdoor air-side inlet port 321a, the air discharged from the fan 800 may be guided to the circulation duct 320. The blower 400 forms an airflow in a direction from the outdoor air-side inlet port 321a toward the outlet port 327a. Therefore, when the second valve 350 is at the position to open the outdoor air-side inlet port 321a, the airflow guided to the outdoor air flow path 340a is guided to the circulation flow path 320a. According to the embodiment, the exhaust port 820 of the fan 800 communicates with the circulation duct 320 through the outdoor air duct 340. In another embodiment, the exhaust port 820 of the fan 800 may be directly connected to the circulation duct 320 to communicate therewith.

In the embodiment, the fan 800 is disposed below the control board 610. According to the embodiment, the control board 610 has a mounting surface on which components are mounted and the mounting surfaces faces downward. By arranging the mounting surface on which the components are mounted facing downward, the components is prevented from accumulating dust thereon and the control box 600 is prevented from overheating.

A heat sink 620 may be disposed in the control board 610. The heat sink 620 may cool an intelligent power module (IPM) disposed in the control board 610. According to the embodiment, the fan 800 is disposed at a position that overlaps the heat sink 620 in a vertical direction.

### <Embodiment of arrangement of fan 800 in control box 600>

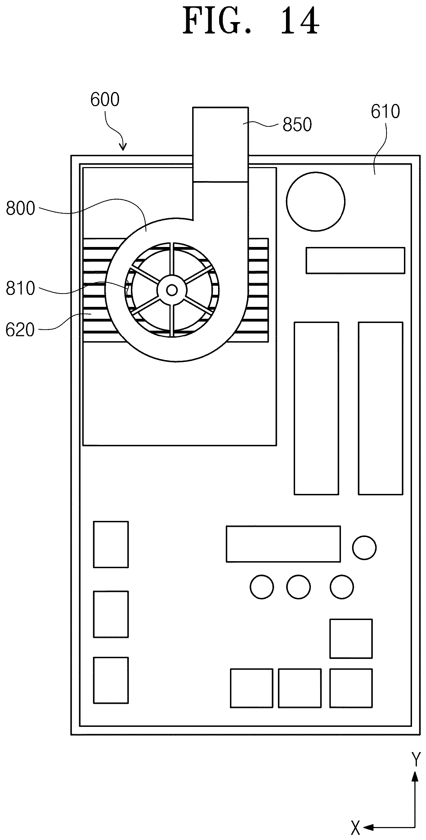

FIG. 14 is a diagram illustrating the arrangement of the fan 800 in the control box 600. FIG. 14 is a diagram the control box 600 viewed from below according to the embodiment.

The control board 610 is disposed in the control box 600. The control board 610 may be arranged so that a mounting surface on which components are mounted faces the floor. The components are individual parts or devices that become a constituent element of a circuit and have independent functions. The heat sink 620 is disposed in the control board 610. The heat sink 620 cools the components of the control board 610. In the embodiment, the heat sink 620 may be configured to cool the IPM of the control board. The heat sink 620 may be disposed to face the IPM.

The fan 800 is disposed at a position that overlaps the heat sink 620 in the vertical direction.

A suction port 810 of the fan 800 is arranged to overlap the heat sink 620 in the vertical direction. The exhaust port 820 of the fan 800 may be arranged to face forward. The exhaust port 820 of the fan 800 is arranged to face in a direction that communicates with the outdoor air. In the embodiment, since a flow path communicating with the outside of the laundry treatment apparatus 1 is formed in the front of the laundry treatment apparatus 1, the exhaust port 820 of the fan 800 is disposed toward the front. The exhaust port 820 of the fan 800 may be connected to a guide pipe 850. The guide pipe 850 may guide an airflow direction of the exhaust port 820.

In the embodiment, the IPM and heat sink 620 are disposed far from the compressor 730. In the embodiment, the IPM and heat sink 620 are disposed on the front side (+Y) of the control board 610. Since the compressor 730 is located on the rear side (-Y) of the base module 1000, separation therebetween may be secured to prevent overheating. Additionally, the refrigerant may leak from the compressor 730, and the IPM is disposed away from the compressor 730, thereby decreasing the concentration of the refrigerant arriving at the IPM and thus reducing the risk of explosion. The fan 800 may form an airflow in a direction away from a portion at which the compressor 730 is disposed. According to the embodiment, since the compressor 730 is disposed at a rear side (-Y) of the base module 1000, the fan 800 may form an airflow toward a front side (+Y) of the base module 1000.

### <Relationship between heat sink 620 and fan 800 according to embodiment>

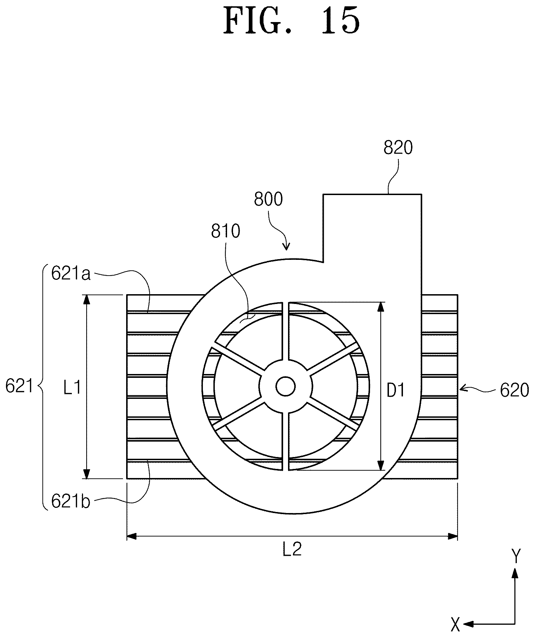

FIG. 15 is a diagram illustrating a relationship between the heat sink 620 and the fan 800 according to an embodiment.

The heat sink 620 includes a plurality of fins 621. The plurality of fins 621 is arranged in a first direction. Among the plurality of fins 621 arranged in the first direction, a distance between the first fin 621a and the last fin 621b may be a first length L1. The plurality of fins 621 may extend in a second direction, which is a direction perpendicular to the first direction. The length by which the plurality of fins 621 extend may be a second length L2.

In the embodiment, the first length L1 is smaller than a diameter D1 of the suction port 810 of the fan 800. According to the embodiment, the second length L2 is larger than the diameter D1 of the suction port 810 of the fan 800.

According to the arrangement of the fan 800 and the heat sink 620 according to the embodiment, a flow path may be formed between the plurality of fins 621, so that heat at a position away from the suction port 810 may be smoothly dissipated.

While the fan 800 serves to form an airflow that discharges a leaking refrigerant, the fan 800 may normally function as a fan that cools the IPM.

When the temperature of the IPM rises above 120 degrees Celsius (C), the compressor 730 stops. Conventionally, there was a phenomenon in which the IPM overheated and the compressor 730 stopped. When applying the structure according to the embodiment of the present disclosure, the temperature of the IPM does not rise above 90 degrees C, so the compressor 730 may be operated continuously. This increases the reliability of the apparatus and may shorten a course time.

### <Airflow discharge structure>

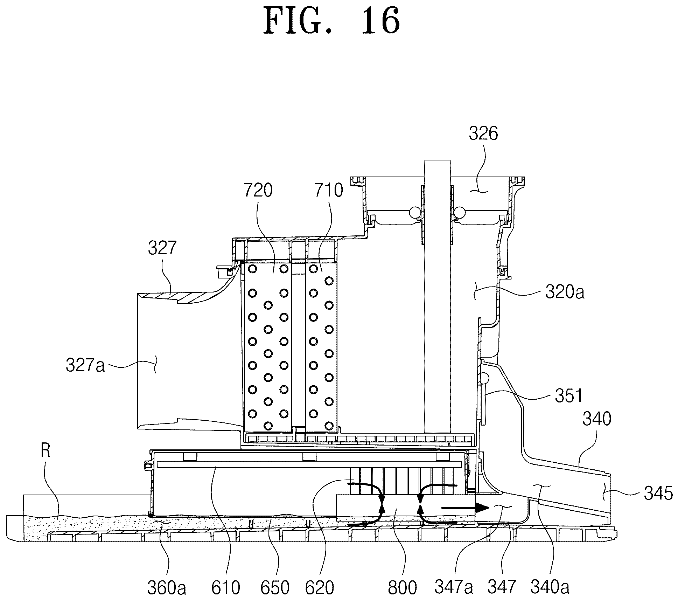

FIG. 16 is a diagram illustrating an airflow discharge structure by the fan 800. As the control board installation portion 360 is located at the lower portion of the base portion 300, a refrigerant R having density higher than the atmosphere, may be accumulated on a bottom surface. The refrigerant R accumulated in the control board installation portion 360 is highly likely to cause ignition in the control board 610. The fan 800 effectively ventilates air in the control board installation portion 360. This has the effect of ensuring stability of the laundry treatment apparatus 1.

In addition, the fan 800 may cool the control board 610 at all times. That is, the fan 800 may function as a cooling fan of the control board 610. When using R-290 refrigerant, power consumption of the compressor 730 increases, and the temperature of the IPM continues to rise, which may cause the compressor 730 to stop. According to the embodiment of the present disclosure, the IPM may be cooled, so the problem of the compressor 730 stopping may be solved.

In the embodiment, the fan 800 is provided as a double inlet blower. The fan 800 is disposed below the heat sink 620. The fan 800 discharges heat from the heat sink 620 upward to the outside. The fan 800 sucks a refrigerant downward and discharges the refrigerant to the outside.

The fan 800 is connected to the outdoor air duct 340. The fan 800 may communicate with the outdoor air duct 340 through the fan communication portion 347. An airflow discharged from the fan 800 flows through the fan communication portion 347 into the outdoor air flow path 340a of the outdoor air duct 340. The airflow discharged from the fan 800 and flowing into the outdoor air flow path 340a is discharged to the outside through the outdoor air inlet port 345 or flows into the circulation flow path 320a and moves to the processing chamber 35, depending on whether the second valve plate 351 is opened.

### <Airflow according to operation state of apparatus>

According to the embodiment, a flow path of the laundry treatment apparatus 1 may be changed depending on a treatment course or cycle. A discharge structure of a refrigerant according to the operating state of the laundry treatment apparatus 1 will now be described with reference to FIGS. 17 to 20.

FIG. 17 is a diagram illustrating a refrigerant discharge path in a steam-using course. Although not shown for convenience of description, the processing chamber 35 is in a state in which laundry is hung.

In the steam-using course, a first circulation flow path that does not pass through a second filter 920 is selected. The second filter 920 may be a HEPA filter. It is desirable that the HEPA filter not be exposed to steam. Therefore, in the steam-using course, a circulating airflow may be sucked into the circulation flow path 320a through the first inlet port 324a in the processing chamber 35 so that the circulating airflow does not pass through the second filter 920. The airflow flowing into the circulation flow path 320a may be dehumidified and heated through the evaporator 710 and the condenser 720 and then be supplied to the processing chamber 35. In the steam-using course, the second valve plate 351 is positioned at a closed position so as not to communicate with outdoor air. The circulation flow path 320a and the outdoor air flow path 340a are separated by the second valve plate 351. A discharge port of the fan 800 communicates with the outdoor air flow path 340a. The airflow discharged from the fan 800 is guided to the outdoor air flow path 340a. The airflow guided to the outdoor air flow path 340a is discharged to the outside of the laundry treatment apparatus 1 through a first flow path 25 formed in the lower portion of the door 20. The first flow path 25 is a flow path through which the door lower portion opening 25a and a door bottom surface opening 25b communicate with each other. The airflow guided to the outdoor air flow path 340a is delivered to the first flow path 25 through the door lower portion opening 25a and discharged to the outside of the laundry treatment apparatus 1 through the door bottom surface opening 25b.

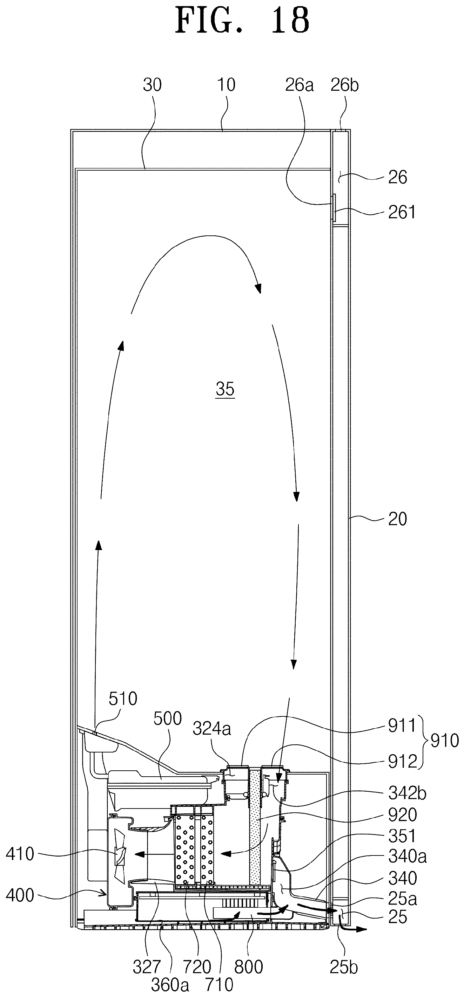

FIG. 18 is a diagram illustrating a refrigerant discharge path in a drying course. Although not shown for convenience of description, the processing chamber 35 is in a state in which laundry is hung

In the drying course, a second circulation flow path passing through the second filter 920 may be selected. In order for the airflow to pass through the second filter 920, the airflow may be sucked into the circulation flow path 320a through the second inlet port 324b in the processing chamber 35. The airflow flowing into the circulation flow path 320a may be filtered through the second filter 920, dehumidified and heated through the evaporator 710 and the condenser 720, and then supplied to the processing chamber 35 again. In the course of drying laundry, the second valve plate 351 is positioned at a closed position to prevent access to outdoor air. The circulation flow path 320a and the outdoor air flow path 340a are separated by the second valve plate 351. The discharge port of the fan 800 communicates with the outdoor air flow path 340a. The airflow discharged from the fan 800 is guided to the outdoor air flow path 340a. The airflow guided to the outdoor air flow path 340a is discharged to the outside of the laundry treatment apparatus 1 through the first flow path 25 formed in the lower portion of the door 20. The airflow guided to the outdoor air flow path 340a is delivered to the first flow path 25 through the door lower portion opening 25a and discharged to the outside of the laundry treatment apparatus 1 through the door bottom surface opening 25b.

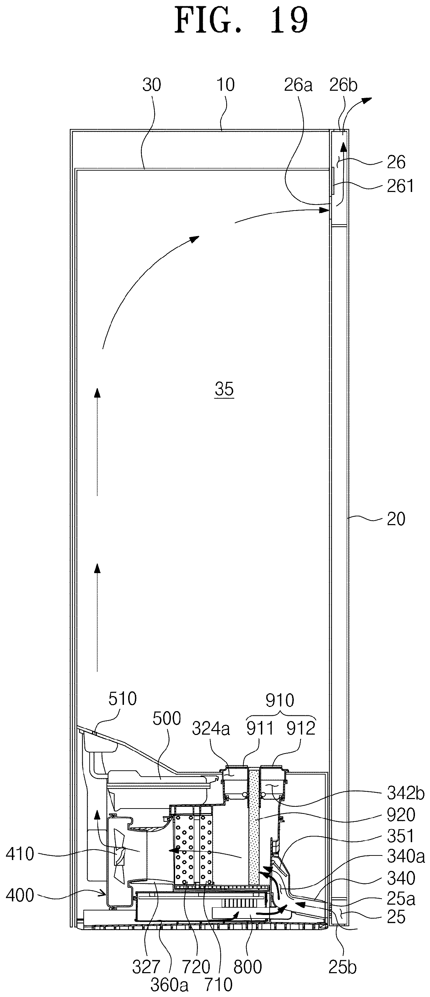

FIG. 19 is a diagram illustrating a refrigerant discharge path in an indoor dehumidification course. The indoor dehumidification course is not a course for treating laundry stored in the processing chamber 35, but a course for dehumidifying a space in which the laundry treatment apparatus 1 is installed. In other words, the indoor dehumidification course is a course in which air outside the laundry treatment apparatus 1 is drawn into the heat exchanger, dehumidified, and discharged again to the outside of the laundry treatment apparatus 1.

When the indoor dehumidification course is selected, the second valve plate 351 is moved to an open position. The circulation flow path 320a and the outdoor air flow path 340a communicate with each other. The first inlet port 324a and the second inlet port 324b are closed. When the blower 400 operates, outdoor air flows into the outdoor air flow path 340a through the first flow path 25 formed in the lower portion of the door 20. The outdoor air flowing into the outdoor air flow path 340a moves to the circulation flow path 320a. The outdoor air flowing into the circulation flow path 320a may be dehumidified and heated through the evaporator 710 and the condenser 720 and then be guided to the processing chamber 35. The air guided to the processing chamber 35 is discharged to the outside of the laundry treatment apparatus 1 through a second flow path 26 formed in the upper portion of the door 20. The second flow path 26 is a flow path through which the door upper portion opening 26a and the door top surface opening 26b communicate with each other. The door upper portion opening 26a of the second flow path 26 is closed by the second flow path opening/closing valve 261 during a laundry treatment course and may be opened when the indoor dehumidification course is selected.

The discharge port of the fan 800 communicates with the outdoor air flow path 340a. An airflow discharged from the fan 800 is guided to the outdoor air flow path 340a. The airflow guided to the outdoor air flow path 340a moves to the circulation flow path 320a along the airflow and moves to the processing chamber 35.

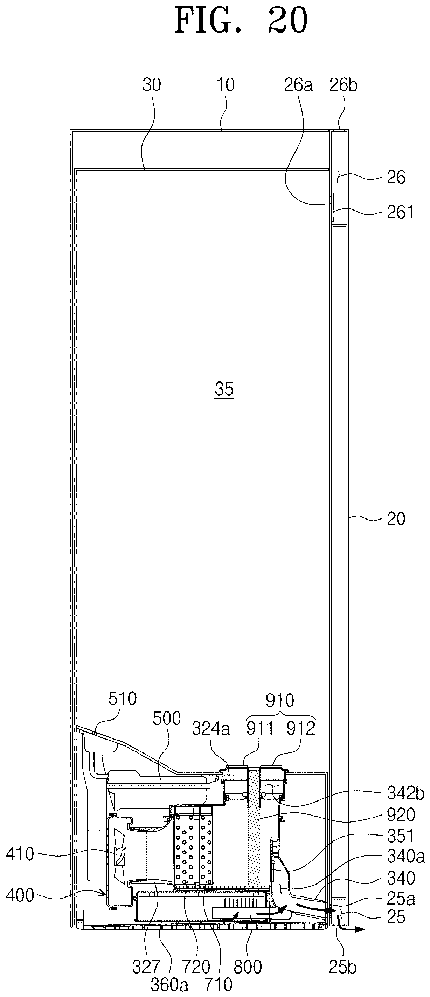

FIG. 20 is a diagram illustrating a refrigerant discharge path in a non-course.

When the laundry treatment apparatus 1 is not in operation or in a non-course, the circulation flow path 320a and the outdoor air flow path 340a are separated by the second valve plate 351. An air flow discharged from the fan 800 is guided to the outdoor air flow path 340a. The airflow guided to the outdoor air flow path 340a is discharged to the outside of the laundry treatment apparatus 1 through the first flow path 25 formed in the lower portion of the door 20.

### <Refrigerant discharge effect and specifications of fan 800>

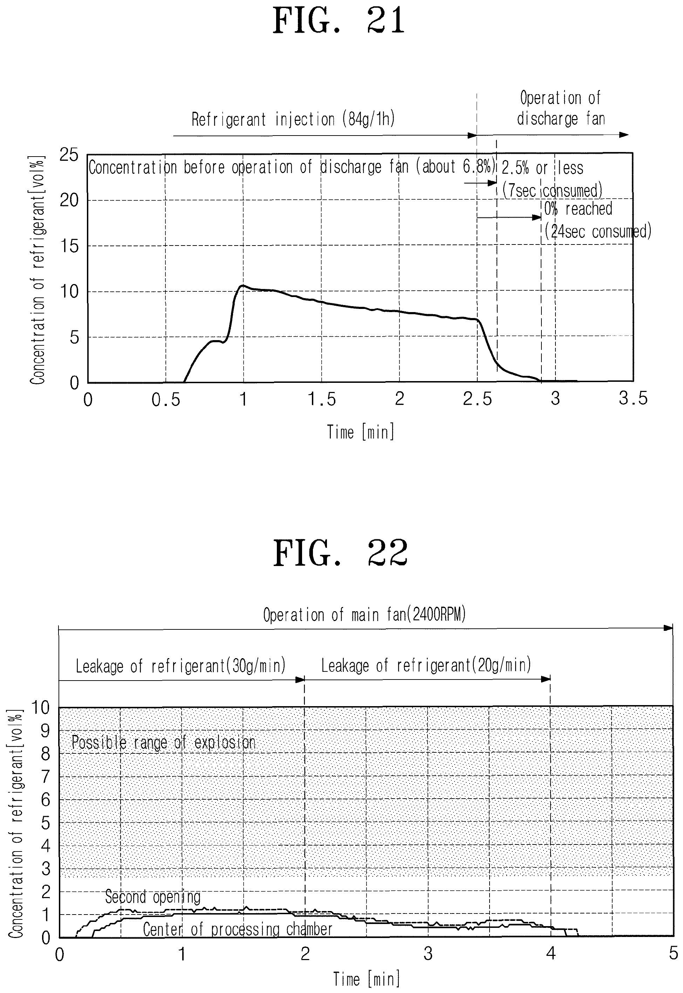

FIG. 21 is an experimental graph for confirming a refrigerant discharge effect. FIG. 21 is a graph measuring refrigerant concentration near the control board 610.

Refrigerant concentration around an ignition point should be diluted below a lower explosion limit. When the refrigerant leaked at 84 g/h as a scenario in which a fine crack occurs in the refrigerant pipe 750, it was confirmed that the refrigerant was maintained at a concentration of 5 to 10%, which is above the lower explosion limit of 2%, but when the fan 800 was driven, the refrigerant concentration decreased to 0% within 30 seconds.

In the embodiment, the fan 800 is provided with a specification capable of reducing the concentration of the refrigerant to below the lower explosion limit within 30 seconds. In the embodiment, the fan 800 is provided as a double inlet centrifugal blower. The exhaust air volume of the fan 800 according to the embodiment is 0.1 m³/min or more.

In the embodiment, the fan 800 is provided with a specification that may increase user convenience by taking noise into consideration. In the embodiment, the fan 800 is provided as a double inlet centrifugal blower. The exhaust air volume of the fan 800 according to the embodiment is 0.16 m³/min or less.

FIG. 22 is an experimental graph for confirming the refrigerant discharge effect. FIG. 22 is a graph measuring refrigerant concentration in a central portion and the second opening 32 of the processing chamber 35 when the laundry treatment apparatus 1 operates in an indoor dehumidification course.

As the blower 400 was driven, the refrigerant was rapidly diluted, and a refrigerant concentration lower than an explosive range was observed in both the central portion and the second opening 32 of the processing chamber 35.

In this specification, specific embodiments have been exemplified. It will be apparent to those skilled in the art in relation to the present disclosure that the specific embodiments shown may be replaced with any reconstruction calculated to achieve the same purpose and that the disclosed present disclosure may be applied differently in different environments. That is, the present application should be understood to cover any application or variation to the presen disclosure. The claims that follow are not limited the scope of the disclosure with respect to specific embodiments of this specification. Therefore, when the modified embodiment includes components of the claims of the present disclosure, the modifications should be regarded as belonging to the scope of the present disclosure.

## Claims

1. A laundry treatment apparatus, comprising:
a cabinet;
a processing chamber located inside the cabinet and configured to accommodate laundry;
a door configured to open and close the processing chamber;
a heat exchanger located inside the cabinet, disposed in a lower portion of the processing chamber, and configured to exchange heat with air of the processing chamber using a flammable refrigerant;
a control board located inside the cabinet, disposed in the lower portion of the processing chamber, and configured to control the heat exchanger; and
a fan configured to cool the control board, disposed at a position adjacent to a floor inside the cabinet, and configured to disperse an airflow of the floor inside the cabinet.

2. The laundry treatment apparatus of claim 1, wherein an exhaust port of the fan communicates with an outside of the cabinet to discharge sucked air to the outside of the cabinet.

3. The laundry treatment apparatus of claim 1, wherein the control board has a mounting surface on which elements are mounted, the mounting surface facing downward, and
wherein the fan is disposed below the control board.

4. The laundry treatment apparatus of claim 3, further comprising a circulation duct located inside the cabinet, disposed in the lower part of the processing chamber, and configured to form a circulation flow path that discharges air introduced from the processing chamber back to the processing chamber,
wherein the control board is disposed below the circulation duct.

5. The laundry treatment apparatus of claim 4, wherein an exhaust port of the fan communicates with the circulation duct, and air discharged from the fan is guided to the circulation duct.

6. The laundry treatment apparatus of claim 1, wherein a heat sink configured to cool an intelligent power module (IPM) is disposed in the control board, and the fan is disposed in the heat sink.

7. The laundry treatment apparatus of claim 6, wherein the fan is provided as a centrifugal blower or a double inlet blower.

8. The laundry treatment apparatus of claim 7, wherein exhaust air volume of the fan is 0.1 m³/min or more and 0.16 m³/min or less.

9. The laundry treatment apparatus of claim 7, wherein the heat sink includes a plurality of fins arranged in a first direction,
wherein a distance between a first fin and a last fin among the plurality of fins arranged in the first direction is smaller than a first length,
wherein the plurality of fins extends to a second length in a second direction perpendicular to the first direction,
wherein the first length is smaller than a diameter of a suction port of the fan, and
wherein the second length is greater than the diameter of the suction port of the fan.

10. The laundry treatment apparatus of claim 7, wherein the heat sink disposed in the control board is disposed far from a compressor constituting the heat exchanger in a front-rear direction.

11. The laundry treatment apparatus of claim 4, further comprising a steam generator configured to generate stream from supplied water,
wherein the steam generator is arranged above the circulation duct.

12. The laundry treatment apparatus of claim 4, further comprising an outdoor air duct configured to communicate with an outside of the cabinet and the circulation duct,
wherein an outlet port of the fan communicates with the outdoor air duct to guide air discharged from the fan to the outdoor air duct.

13. The laundry treatment apparatus of claim 11, wherein the circulation duct comprises:
a chamber-side inlet port configured to communicate with the processing chamber and provided to be opened and closed; and
an outdoor air-side inlet port configured to communicate with the outdoor air duct and provided to be open and closed,
wherein air discharged from the fan when the outdoor air-side inlet port is closed is guided to an outside of the cabinet, and
wherein the air discharged from the fan when the chamber-side inlet port is closed and the outdoor air-side inlet port is opened is guided to the circulation duct.

14. The laundry treatment apparatus of claim 13, further comprising a circulation fan configured to form air pressure to cause an airflow inside the circulation duct to be directed from an upstream direction to a downstream direction,
wherein the air discharged from the fan when the chamber-side inlet port is closed and the outdoor air-side inlet port is open is guided to the circulation duct by the air pressure.

15. The laundry treatment apparatus of claim 14, wherein the door is provided with
a first flow path configured to communicate with the outdoor air duct and an outside of the laundry treatment apparatus at a position at which the door closes the processing chamber, and
a second flow path configured to communicate with the processing chamber and the outside of the laundry treatment apparatus at a position at which the door closes the processing chamber, and
wherein the air discharged from the fan when the chamber-side inlet port is closed and the outdoor air-side inlet port is opened is guided to the circulation duct by the air pressure, flows into the processing chamber, and then flows into the outside of the cabinet through the second flow path.
